(19) Europäisches Patentamt / European Patent Office / Office européen des brevets

(11) **EP 4 516 751 A1**

(12) **EUROPEAN PATENT APPLICATION**

(43) Date of publication:
**05.03.2025 Bulletin 2025/10**

(21) Application number: **24192913.2**

(22) Date of filing: **05.08.2024**

(51) International Patent Classification (IPC):
**C03C 17/36** (2006.01)    **C03C 17/40** (2006.01)
**C03C 23/00** (2006.01)

(52) Cooperative Patent Classification (CPC):
**C03C 23/006; C03C 17/3639; C03C 17/3649;
C03C 17/40;** C03C 2204/08

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.08.2023 US 202363535305 P**

(71) Applicant: **Absolics Inc.**
**Covington, GA 30014 (US)**

(72) Inventors:
• **KIM, Jincheol**
  **Hwaseong-si, Gyeonggi-do 18469 (KR)**
• **LEE, Changyeoul**
  **Covington, Georgia 30014 (US)**
• **LEE, Bongyeol**
  **Covington, Georgia 30014 (US)**

(74) Representative: **BCKIP Part mbB**
**MK1**
**Landsbergerstraße 98, 3.Stock**
**80339 München (DE)**

(54) **SUBSTRATE AND MANUFACTURING METHOD FOR THE SAME**

(57)    A substrate according to an embodiment includes a glass core having a top surface. The top surface of the glass core has a value of $R_{q*k}$, bond roughness index of Equation 1 below, from 3.5 nm to 150 nm.

[Equation 1]

$$R_{q*k} = Rq \times Rku^2$$

In Equation 1 above, the value of Rq is root mean square deviation (in nm) and the value of Rku is kurtosis.

For these substrates, an electrically conductive layer can be implemented that has substantially uniformly improved adhesion to the glass core and can efficiently transmit signals even when high-frequency power is applied.

[FIG. 3]

EP 4 516 751 A1

**Description**

**TECHNICAL FIELD**

The following description relates to substrates and methods of manufacturing them.

**BACKGROUND**

When manufacturing electronic components, implementing the circuitry on a semiconductor wafer is called the Front-End (FE), and assembling the wafer into a productready state is called the Back-End (BE), which includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively weak. Therefore, the electrical performance of semiconductors is often determined by packaging technology and electrical connections rather than the performance of the semiconductor technology itself.

Packaging substrates can be made of ceramic or resin. Ceramic substrates have high resistivity or high dielectric constant, making it difficult to mount high-performance, high-frequency semiconductor devices. In the case of resin substrates, it is possible to mount relatively high-performance high-frequency semiconductor devices, but there are limitations in reducing the pitch of the wiring.

Recently, researchers have been exploring on the use of silicon or glass as high-end packaging substrates. By forming through-holes in the silicon or glass substrate and filling them with conductive materials, the wiring length between the device and the motherboard can be reduced, resulting in improved electrical performance.

**SUMMARY**

A substrate according to one embodiment of the present disclosure includes a glass core having a top surface.

The glass core top surface has a value of $R_{q*k}$, bond roughness index in Equation 1 below, of 3.5 nm to 150 nm.

[Equation 1]

$$R_{q*k} = Rq \times Rku^2$$

In Equation 1 above, the value of Rq is root mean square deviation (in nm) and the value of Rku is kurtosis.

The Rq may be from 0.25 nm to 5 nm.

The Rku may be 3 or higher.

The glass core top surface may have a total of three arbitrarily selected measurement zones.

A standard deviation of the Rq values in each of the above measurement regions may be 0.15 nm or less.

A standard deviation of the Rku values in each of the above measurement regions may be 1 or less.

The substrate may include an electrically conductive layer disposed on the glass core.

The electrically conductive layer may include a seed layer and a conductive layer disposed on the seed layer.

Thickness of the seed layer may be from 50 nm to 1500 nm.

The electrically conductive layer may have a patterned shape.

Width of the electrically conductive layer may be from 1 $\mu$m to 5 $\mu$m.

Thickness of the electrically conductive layer may be from 1 $\mu$m to 5 $\mu$m.

The electrically conductive layer may comprise a first electrically conductive layer formed abutting the glass core surface.

When observed in a cross-section of the first electrically conductive layer, Rz, maximum height roughness of the interface formed between the first electrically conductive layer and the glass core, may be 5 nm to 200 nm.

Bonding force between the first electrically conductive layer and the glass core, as measured by a 180° peel test, may be greater than or equal to 0.25 kgf.

The substrate may have a semiconductor packaging use.

A method of manufacturing a substrate according to another embodiment of the present disclosure includes a preparation operation of preparing a base glass plate and a roughening operation of preparing a substrate comprising a glass core formed by roughening a top surface of the base glass plate.

The glass core has a top surface.

The glass core top surface has a value of $R_{q*k}$, bond roughness index of Equation 1 below, of 3.5 nm to 150 nm.

[Equation 1]

$$R_{q*k} = Rq \times Rku^2$$

In Equation 1 above, the Rq is root mean square deviation (in nm) and the Rku is kurtosis.

The roughening operation may comprise plasma treating the top surface of the base glass plate to form a glass core.

## BRIEF DESCRIPTION OF THE DRAWINGS

Figure 1 is a top view illustrating a substrate according to one embodiment of the present disclosure.
Figure 2 is a top view illustrating a substrate according to yet another embodiment of the present disclosure.
Figure 3 is a top view illustrating a substrate according to still another embodiment of the present disclosure.
Figure 4 is a top view illustrating a substrate according to a further another embodiment of the present disclosure.

## DETAILED DESCRIPTION

The present disclosure is hereinafter described in detail with reference to the accompanying drawings, which illustrate embodiments that will be implemented by one having ordinary skill in the art to which the disclosure belongs. However, the disclosure may be implemented in many different forms and is not limited to the embodiments described herein. Throughout the specification, like parts are designated by the same drawing designations.

Throughout this specification, the term "combination thereof" as used in a Makushi-style representation means one or more mixtures or combinations selected from the group of components described in the Makushi-style representation and includes one or more selected from the group of components.

Throughout this specification, terms such as "first," "second," or "A," "B," are used to distinguish one and the same term from another. In addition, expressions in the singular include the plural unless the context clearly indicates otherwise.

As used herein, a "~" group may mean that the compound includes a compound corresponding to "-" or a derivative of"-".

As used herein, the reference to B being located on A means that B is located on A either directly abutting A or on A with another layer between them, and is not to be construed as limited to B being located abutting the surface of A.

In this specification, the reference to B is connected to A means a direct connection between A and B or a connection between A and B through another component and shall not be construed to be limited to a direct connection between A and B unless otherwise noted.

In this specification, singular expressions shall, unless otherwise indicated, be construed to include the singular or plural as construed from the context.

The shapes, relative sizes, angles, etc. of the configurations shown in the drawings in this specification are exemplary and may be exaggerated for purposes of illustration, and the rights are not to be construed as limited to the drawings.

As used herein, when A and B are adjacent, it means that A and B are in contact to each other, or that A and B are not in contact to each other but are close to each other. In this specification, the expression A and B are adjacent shall not be construed to mean that A and B are in contact to each other unless otherwise indicated.

As used herein, high frequency refers to frequencies from about 1 GHz to about 300 GHz. More specifically, it can mean a frequency of about 1 GHz to about 30 GHz, or it can mean a frequency of about 1 GHz to about 15 GHz.

As used herein, a fine line means a line having a width of 5 $\mu$m or less, unless otherwise specified, and exemplarily means a line having a width of 1 to 4 $\mu$m or less.

The inventors of the embodiment have found that by controlling the roughness characteristics of the glass core surface, it is possible to implement an electrically conductive layer that has a uniformly improved bonding force on the glass core surface and can efficiently transmit signals by suppressing excessive resistance increase of the electrically conductive layer when applying high-frequency power.

Below, the present disclosure is described.

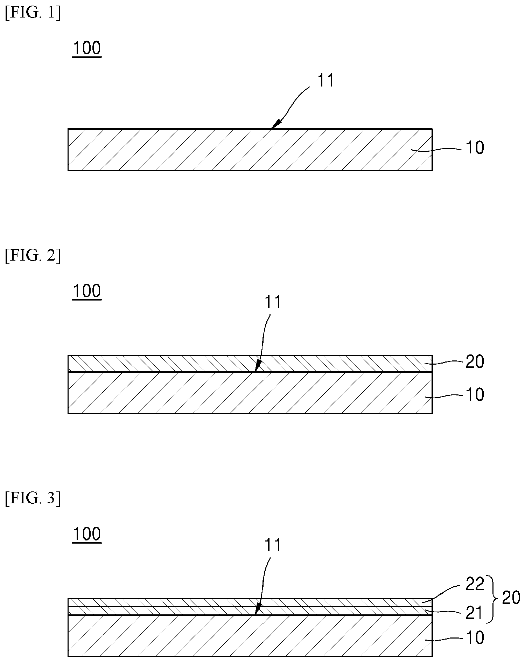

FIG. 1 is a perspective view illustrating a substrate according to one embodiment of the present disclosure.

Referring now to FIG. 1, the substrate of an embodiment will be described.

**Glass Core**

A substrate 100 according to one embodiment of the present disclosure includes a glass core 10 having a top surface 11.

The glass core 10 serves as a support in the substrate 100. The glass core 10 is distinct from a core distribution layer (not shown) or bump (not shown) disposed above or below the glass core 10.

Embodiments may apply a glass material core to suppress the occurrence of parasitic elements in the core and power losses due to high frequency power application.

The material of the glass core 10 may be, for example, alkaline borosilicate, alkali-free borosilicate, alkali-free alkali earth metal borosilicate, and the like, and may be applied as long as it is a plate glass material applied to an electronic component.

Thickness of the glass core 10 may be 50 μm or more. The thickness may be 100 μm or more. The thickness may be 250 μm or more. The thickness may be 400 μm or more. The thickness may be 500 μm or more. The thickness may be 3000 μm or less. The thickness may be 2000 μm or less. The thickness may be 1000 μm or less. When the glass core 10 having such a thickness is applied, it can have excellent utilization as a core for semiconductor packaging.

The glass core top surface 11 has a value of $R_{q*k}$, bond roughness index of Equation 1 below, from 3.5 nm to 150 nm.

[Equation 1]

$$R_{q*k} = Rq \times Rku^2$$

In Equation 1 above, the value of Rq is root mean square deviation (in nm) and the value of Rku is kurtosis.

In order to improve the bonding force of the electrically conductive layer to the glass core top surface 11, it may be considered to simply increase the roughness of the glass core top surface 11. However, in this case, a problem may arise that the deviation of the roughness characteristics of the glass core top surface 11 becomes larger than a certain level. If an electrically conductive layer is formed on such a top surface 11, the electrically conductive layer may exhibit an uneven bonding force throughout. This can be a factor that reduces the peel resistance of the electrically conductive layer and the electrical reliability of the substrate.

Furthermore, if an electrically conductive layer is formed on the glass core top surface 11 of the glass core having a high roughness, the resistance of the electrically conductive layer formed on the core may be excessively high when high-frequency power is supplied. Specifically, when high-frequency power is applied to the substrate 100 to improve the signal transmission speed and transmission amount, a skin effect may occur on the electrically conductive layer, and current may flow concentrated on the surface of the electrically conductive layer.

When an electrically conductive layer is formed on the glass core top surface 11 with an excessively high roughness, at least a portion of the cross-sectional profile of the electrically conductive layer may have a rough and amorphous shape. When a high-frequency current flows through an electrically conductive layer having such a shape, the area through which the current can substantially flow within the electrically conductive layer is reduced, and the resistance of the electrically conductive layer may be significantly increased. The increase in resistance of the electrically conductive layer due to the skin effect can be greater as the electrically conductive layer becomes finer.

Embodiments may control the value of $R_{q*k}$, the bond roughness index of the glass core top surface 11. In such a case, a more stable interlocking structure can be formed between the glass core 10 and the electrically conductive layer without excessively increasing the roughness of the glass core top surface 11 on the glass core 10, and the glass core top surface 11. Thus, the bonding force of the electrically conductive layer as a whole can be effectively improved. Furthermore, the substrate 100 having the above features enables the electrically conductive layer to exhibit stable resistance characteristics even when high-frequency power is applied.

$R_{q*k}$ values are measured in the following method.

The root mean square deviation value, Rq, and the kurtosis value, Rku, are measured in non-contact mode using an Atomic Force Microscope according to the method specified in ISO 4287 in a total of three measuring areas (not shown) of 5 μm in width and 5 μm in length randomly selected from the top surface of the glass core 11. The measurement areas are selected so that they do not overlap each other. An exemplary atomic force microscope is the XE-100 model from Park Systems.

The average value of the Rq value of the above measuring areas is taken as the Rq value of the top surface of the glass core. The average value of the Rku value of the above measuring areas is taken as the Rku value of the top surface of the glass core. From the above values, the $R_{q*k}$ value is calculated according to Equation 1.

The $R_{q*k}$ value of the glass core top surface 11 may be from 3.5 nm to 150 nm. The $R_{q*k}$ value may be 6 nm or more. The $R_{q*k}$ value may be 10 nm or more. The $R_{q*k}$ value may be greater than or equal to 15 nm. The value of $R_{q*k}$ may be 20 nm or more. The $R_{q*k}$ value may be greater than or equal to 30 nm. The $R_{q*k}$ value may be greater than or equal to 35 nm. The $R_{q*k}$ value may be 120 nm or less. The $R_{q*k}$ value may be 100 nm or less. The value of $R_{q*k}$ may be 70 nm or less. In such a case, when forming a fine electrically conductive layer on the glass core 10, bonding force of the electrically conductive layer to the glass core 10 can be improved substantially uniformly throughout the glass core top surface 11, while suppressing the resistance of the electrically conductive layer from becoming excessively high when a high-frequency power is applied.

The Rq value of the glass core top surface 11 may be from 0.25 nm to 5 nm. The Rq value may be greater than or equal to 0.3 nm. The Rq value may be 0.5 nm or more. The Rq value may be greater than or equal to 1 nm. The Rq value may be greater than or equal to 1.5 nm. The Rq value may be 3 nm or less. In such a case, an electrically conductive layer can be implemented on the glass core 10 that is stably fixed on the glass core 10 and whose resistance characteristics do not increase excessively even when high-frequency power is applied.

The glass core top surface 11 may have an Rku value of 3 or more. The Rku value may be 4 or more. The Rku value may be 5 or more. The Rku value may be 7 or more. The Rku value may be 15 or less.

In this case, a strongly bonded structure can be formed between the top surface of the glass core and the electrically conductive layer. In this way, the adhesion of the electrically conductive layer to the surface can be effectively improved without excessively roughing the surface of the glass core.

Embodiments may control the variation in roughness characteristics of the plurality of different regions to help ensure that the bonding force of the electrically conductive layer to the glass core 10 and resistance characteristics of the electrically conductive layer appear evenly across the glass core top surface 11.

The glass core top surface 11 may have a total of three arbitrarily selected measurement area.

The measurement area is an area 5 $\mu$m wide and 5 $\mu$m long located on the top surface of the glass core. The three measurement areas may be selected so that they do not overlap each other.

The standard deviation of the Rq values in each of the above measurement area may be 0.15 nm or less.

The standard deviation of the Rku values in each of the above measurement area may be 1 or less.

The standard deviation above is the sample standard deviation.

The standard deviation of the Rq values in each measurement area may be 0.15 nm or less. The standard deviation may be 0.1 nm or less. The standard deviation may be 0.08 nm or less. The standard deviation may be 0.05 nm or less. The standard deviation may be greater than or equal to 0.001 nm.

The standard deviation of the Rku values in each measurement area may be 1 or less. The standard deviation may be 0.8 or less. The standard deviation may be 0.6 or less. The standard deviation may be 0.4 or less. The standard deviation may be greater than or equal to 0.1.

In this case, the roughness characteristics can be adjusted evenly across the glass core top surface 11.

The glass core bottom surface may have a roughness characteristic such as those of the glass core top surface 11 described above. In such a case, the glass core bottom surface can support an electrically conductive layer having an evenly enhanced bonding force throughout, and the electrically conductive layer can efficiently transmit signals even when applying high-frequency power.

The description of the illumination characteristics of the bottom surface of the glass core is redundant to the previous section.

## Core Distribution Layer

FIG. 2 is a perspective view illustrating a substrate according to another embodiment of the present disclosure. Referring to FIG. 2, the substrate of this embodiment will be described.

The substrate 100 includes a glass core 10 having a top surface 11. The specific configurations of the substrate 100 described in FIG. 1 are applied in same manner in the present drawing. Differences will be discussed below.

The substrate of this embodiment may include an electrically conductive layer 20 disposed on a glass core. The electrically conductive layer 20 may have a patterned shape. The electrically conductive layer 20 may be formed on and/or under the glass core 10 to function to transmit signals.

Width of the electrically conductive layer 20 may be from 1 $\mu$m to 5 $\mu$m. The width may be 4.5 $\mu$m or less. The width may be 4 $\mu$m or less.

Thickness of the electrically conductive layer 20 may be from 1 $\mu$m to 5 $\mu$m. The thickness may be 4.5 $\mu$m or less. The thickness may be 4 $\mu$m or less.

In such cases, a high-density pattern of electrically conductive layers 20 can be implemented on the substrate 100 and the technical features can help the electrically conductive layers 20 have stable resistive characteristics even when at high frequency currents are applied.

FIG. 3 is a perspective view illustrating a substrate according to another embodiment of the present disclosure.

Referring now to FIG. 3, the substrate of the embodiment will be described.

The substrate 100 includes a glass core 10 having a top surface 11. The specific configurations of the substrate 100 described in FIGs. 1 and 2 are applied in same manner in the present drawing. Differences will be discussed below.

The electrically conductive layer 20 may include a seed layer 21 and a conductive layer 22 disposed on the seed layer 21.

The seed layer 21 may exhibit a certain level of adhesion to the surface to be bonded (in particular, the glass core top surface 11). The conductive layer 22 may be reliably bonded to the surface of the glass core 10 via the seed layer 21.

The seed layer 21 may comprise a metal element different from the metal element applied to the conductive layer. The seed layer 21 may further comprise a metal element different from the metal element applied to the conductive layer. The seed layer 21 may include a first seed layer (not shown) comprising an element different from the metal element applied to the conductive layer, and a second seed layer (not shown) disposed on the first seed layer and comprising the same element as the metal element applied to the conductive layer. For example, the first seed layer may comprise a material such as titanium, chromium, nickel, or the like, and the second seed layer may comprise a material such as copper, nickel, aluminum, gold, or silver, or the like.

At least a portion of the seed layer 21 may be formed via a sputtering process. The seed layer 21 may facilitate the formation of the conductive layer 22 on the glass core 10.

Embodiments may adjust the thickness of the seed layer 21 to form a structure in which the seed layer 21 reliably interlocks the glass core top surface 11 with a controlled roughness characteristic.

The thickness of the seed layer 21 may be from 50 nm to 1500 nm. The thickness may be 80 nm or more. The thickness may be 100 nm or more. The thickness may be 150 nm or more. The thickness may be 200 nm or more. The thickness may be 250 nm or more. The thickness may be 300 nm or more. The thickness may be 1200 nm or less. The thickness may be 1000 nm or less.

In such a case, the seed layer 21 can help the electrically conductive layer 20 to have good bonding force, and the electrically conductive layer 20 can be formed efficiently.

The conductive layer 22 may be formed by a plating process on the seed layer 21. An electrically conductive material may be applied as the material of the conductive layer 22. Exemplarily, the conductive layer 22 may comprise at least one of copper, nickel, aluminum, gold, or silver.

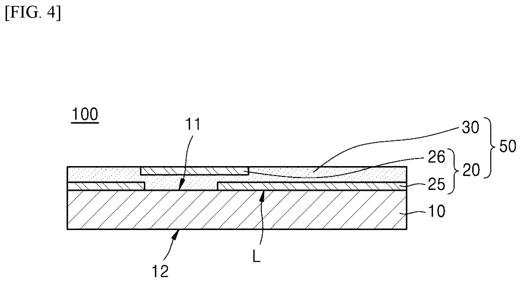

FIG. 4 is a perspective view illustrating a substrate according to another embodiment of the present disclosure. Referring now to FIG. 4, the substrate of this embodiment will be described.

The substrate 100 includes a glass core 10 having a top surface 11. The specific configurations of the substrate 100 described in FIGs. 1 to 3 are applied in same manner in the present drawing. Differences will be discussed below.

The substrate 100 may include a core distribution layer 50 disposed on the glass core 10. The core distribution layer 50 may include an electrically conductive layer 20 and an insulating layer 30 surrounding at least a portion of the electrically conductive layer 20.

In the core distribution layer 50, the insulating layer 30 and the electrically conductive layer 20 may be arranged in mixed manner. The core distribution layer 50 may be formed with the electrically conductive layer 20 embedded within the insulating layer 30 in a predetermined location and shape. In at least a portion of the core distribution layer 50, the electrically conductive layers 20 may be formed in fine line.

The core distribution layer 50 may be formed by a process of repeatedly forming and removing the insulating layer 30 and the electrically conductive layer 20.

The insulating layer 30 can be any insulating layer that can be applied to a semiconductor device or packaging substrate as an insulating layer. The insulating layer 30 may be an epoxy-based resin including fillers, for example. The insulating layer 30 may be formed by, but is not limited to, a build-up layer material such as Ajinomoto Build-up Film (ABF) from Ajinomoto, an undercoat material, and the like.

The insulating layer 30 may be formed by laminating and then curing an uncured or semi-cured insulator film.

The electrically conductive layer 20 may include a first electrically conductive layer 25 disposed in contact to the surface of the glass core 10. The electrically conductive layer 20 may also include a second electrically conductive layer 26 that is not in contact to the surface of the glass core 10.

When observed in a cross-section of the first electrically conductive layer 25, a value of Rz, maximum height roughness of the interface (L) formed between the first electrically conductive layer 25 and the glass core 10, may be from 5 nm to 200 nm.

Embodiments may control the roughness characteristics of the interface L formed between the first electrically conductive layer 25 and the glass core 10. This allows for stable control of the resistance and heat generation characteristics of the first electrically conductive layer 25 due to the skin effect, while further improving the adhesion of the first electrically conductive layer 25 to the glass core 10 due to the anchor effect.

The Rz value of the interface L is measured by the following method.

A cross-section of the first electrically conductive layer 25 is prepared for imaging using a transmission electron microscope (TEM). A cross-section of the first electrically conductive layer 25 means a cross-section in a direction perpendicular to the glass core top surface 11 of the glass core. If the first electrically conductive layer 25 has a patterned shape, a cross-section of the first electrically conductive layer 25 means a cross-section in a direction perpendicular to the glass core top surface 11 of the glass core and perpendicular to the longitudinal direction of the first electrically conductive layer 25. From the cross-sectional image of the first electrically conductive layer 25, a profile of the interface L formed between the first electrically conductive layer 25 and the glass core 10 is traced, and a value of Rz, the maximum height roughness of the interface (L), is calculated from the traced profile.

The Rz value is measured according to the method specified in ISO 4287. Specifically, in the traced profile of the interface (L), the sum of the height of the highest peak and the depth of the deepest valley is the Rz value.

The Rz value of the interface (L) formed between the first electrically conductive layer and the glass core may be 200 nm or less. The Rz value may be 180 nm or less. The Rz value may be 150 nm or less. The Rz value may be 100 nm or less. The Rz value may be greater than or equal to 5 nm. The Rz value may be greater than or equal to 10 nm. In such a case, a first electrically conductive layer 25 having good adhesion and that is suitable for applying high frequency power can be implemented on the surface of the glass core 10.

Embodiments may control the bonding force of the first electrically conductive layer 25 to the glass core surface above a certain level to improve the peel resistance of the first electrically conductive layer 25.

The bonding force value between the first electrically conductive layer 25 and the glass core 10 as measured by the 180° peel test is measured using a bond tester. When measuring the bonding force value, the measuring speed (peeling speed) is set to 10 mm/s and the measuring distance (peeling distance) is set to 70 mm. Exemplarily, the bonding force value can be measured with a Condor Sigma bond tester from XYZ TEC.

The bonding force between the first electrically conductive layer 25 and the glass core 10, as measured by a 180° peel test, may be 0.25 kgf or more. The bonding force may be 0.3 kgf or more. The bonding force may be 0.4 kgf or more. The bonding force may be 5 kgf or less. The bonding force may be 3 kgf or less. In such cases, the electrically conductive layer 20 may be reliably bonded to the surface of the glass core 10.

## Other components on the packaging board

The glass core 10 may include a core via (not shown) that penetrates the glass core 10 in the thickness direction. A core distribution layer 50 may be formed on the glass core top surface 11 and within the core vias. The core distribution layer 50 may be formed over the glass core top surface 11, below the glass core bottom surface 12, and within the core via. In this case, the core distribution layer 50 may connect the top surface 11 and the bottom surface 12 of the glass core over a relatively short distance. Furthermore, electrical signals can be transmitted more quickly between the device disposed on the top surface of the substrate 100 and the motherboard disposed under the bottom surface of the substrate 100, and the occurrence of signal loss can be suppressed.

The core via may include an inner space and a side surface surrounding the inner space. In the core via, an electrically conductive layer may be formed abutting the side surface of the core via. The electrically conductive layer may be formed by filling the inner space of the core via.

The core via may be formed by processing a predetermined area within the glass core 10. Specifically, it may be formed by etching the glass core 10 by physical and/or chemical means. For example, a method of forming a core via may include forming defects on the surface of the glass core 10, such as by laser, followed by chemical etching, laser etching, or the like.

A cavity region (not shown) in which an element is mounted may be disposed in the glass core 10. The cavity region may include a receiving portion, which is a space formed by the removal of a portion of the glass core 10. The receiving portion may be formed by penetrating of the glass core 10. The receiving portion may be formed by a removal of a portion of the top or bottom of the glass core 10.

An element may be mounted in the receiving portion. The element is not only a semiconductor device such as a CPU, GPU, memory chip, etc. but also a capacitor device, transistor device, impedance device, other module, etc. In other words, any element mounted on a semiconductor component can be applied as the element without limitation.

The substrate 100 may further include a top layer (not shown) above the core distribution layer 50 disposed on the glass core 10.

The top layer may include a top distribution layer and a top contact layer disposed on the top substrate layer. An element mounted on the substrate 100 may be electrically connected to the substrate 100 via the top surface contact layer.

The top distribution layer may include an electrically conductive layer and an insulating layer surrounding at least a portion of the electrically conductive layer. The electrically conductive layer and the insulating layer of the top distribution layer may each be made of the same material as the electrically conductive layer and the insulating layer of the core distribution layer. The top distribution layer may electrically connect the device and the core distribution layer.

The substrate 100 may further include a bottom layer (not shown) below the core distribution layer 50 (not shown) disposed under the glass core bottom surface 12.

The bottom layer may include a bottom distribution layer and a bottom contact layer disposed below the bottom distribution layer. A main board disposed below the substrate 100 may be electrically connected to the substrate 100 via the bottom contact layer. The core distribution layer may be electrically connected to the main board via the bottom layer.

The bottom distribution layer may include an electrically conductive layer and an insulating layer surrounding at least a portion of the electrically conductive layer. The electrically conductive layer and the insulating layer of the bottom distribution layer may each be made of the same material as the electrically conductive layer and the insulating layer of the core distribution layer.

The substrate 100 may have semiconductor packaging use. The substrate 100 can be utilized for mounting semiconductor devices, protecting semiconductors, and providing electrical connections between the devices and the main board.

## Semiconductor package

A semiconductor package according to another embodiment of the present disclosure includes a substrate 100 and a main board (not shown) electrically coupled to the substrate.

The substrate 100 may be mounted on a main board and electrically connected to the main board. The main board is not limited as long as it is commonly applied in the field of semiconductor devices.

The description of the substrate 100 is redundant to the preceding and will be omitted.

## A method of manufacturing a substrate

A method of manufacturing a substrate according to another embodiment of the present disclosure includes a preparation operation of preparing a base glass plate and a roughening operation of preparing a substrate comprising a glass core formed by roughening the top surface of the base glass plate.

The glass core has a top surface, and the top surface of the glass core has a value of $R_{q*k}$, the bond roughness index of Equation 1 below, of 3.5 nm to 150 nm.

[Equation 1]

$$R_{q*k} = Rq \times Rku^2$$

In Equation 1 above, the value of Rq is root mean square deviation (in nm) and the value of Rku is kurtosis.

In the operation of roughening, a base glass plate may be processed to prepare the glass core.

The base glass plate may be any plate glass material applied to an electronic component. For example, the base glass plate may be an alkaline borosilicate glass plate, an alkali-free borosilicate glass plate, an alkali-free alkali earth metal borosilicate glass plate, etc. Commercially available base glass plates include, for example, those manufactured by Corning, Schott, AGC, and others.

The operation of roughening in an embodiment may comprise plasma treating the top surface of the base glass plate to form a glass core. The roughening operation may comprise plasma treating the top surface of the base glass plate with an inert gas to form a glass core. This may result in a glass core having a top surface with controlled roughness characteristics such that the roughness is not excessively high and has skewness in a predetermined range in the embodiment.

The inert gas may be anyone selected from the group consisting of helium gas, argon gas, xenon gas, krypton gas, and combinations thereof. The inert gas may be an argon gas. In such cases, the inert gas may help to form a glass core having the surface roughness characteristics desired in the embodiment while inhibiting chemical denaturation of the base glass plate top surface during the roughening operation.

In the roughening operation, the atmospherer pressure may be 100 mTorr or less. The atmospherer pressure may be 80 mTorr or less. The atmospherer pressure may be 50 mTorr or less. The atmospherer pressure may be 30 mTorr or less. The atmospherer pressure may be greater than or equal to 1 mTorr. In such a case, the inert gas ionized during the roughening operation may collide on the surface to be roughened without undue disturbance, thereby facilitating control of the roughness characteristics of the glass core top surface.

In the roughening operation, the flow rate of the inert gas introduced may be 100 sccm or more. The flow rate may be greater than or equal to 150 sccm. The flow rate may be greater than or equal to 200 sccm. The flow rate may be 1000 sccm or less. In such cases, a sufficient amount of ionized inert gas may collide on the top surface of the base glass plate at a suitably controlled rate.

The source power may be 0.1 kW or more during the roughening operation. The source power may be 0.3 kW or more. The source power may be 0.5 kW or more. The source power may be 5 kW or less.

The bias power may be 0.1 kW or more during the roughening operation. The bias power may be 0.3 kW or more.

The bias power may be 0.5 kW or more. The bias power may be greater than or equal to 1 kW. The bias power may be 8 kW or less. The bias power may be 5 kW or less.

In such cases, the kinetic velocity of the ionized inert gas can be controlled within a suitable range to help form a glass core with the desired surface roughness characteristics of the embodiment.

The roughening operation may be carried out for more than 10 seconds. The roughening operation may be carried out for more than 15 seconds. The roughening operation may be carried out for more than 30 seconds. The roughening operation may be carried out for 1000 seconds or less. The roughening operation may be carried out for 500 seconds or less. The roughening operation may be carried out for 300 seconds or less. This can help form a glass core top surface having a roughness and asymmetry within a predetermined range in an embodiment.

The roughening operation may be performed not only on the top surface of the base glass, but also on the bottom surface. The roughening operations described above may be applied to the bottom surface of the base glass plate.

If desired, a core via can be formed in the glass core. Specifically, defects can be formed at predetermined locations on the surface of the glass core. Physical or chemical etching may be applied to form the core vias. A description of a method for forming a core via is omitted as it is redundant to the foregoing.

The method of manufacturing the substrate of an embodiment may further comprise the operation of forming a core distribution layer on the glass core.

The description of the core distribution layer is redundant to the previous section.

The operation of forming the core distribution layer may include forming an electrically conductive layer on the glass core; and forming an insulating layer surrounding at least a portion of the electrically conductive layer.

In the process of forming the electrically conductive layer, in an embodiment, a seed layer can be formed by applying an ion beam deposition under a predetermined conditions to suppress excessive deviation in the roughness characteristics of the glass core top surface due to the collision of the sputter particles against the glass core top surface. In this way, the seed layer formed by sputtering may form a stable interlocking structure with the glass core surface throughout the glass core top surface, contributing to the improvement of the bonding force of the electrically conductive layer. In addition, it can help to effectively suppress the increase in resistance of the electrically conductive layer caused by the skin effect.

The seed layer can include a first seed layer comprising a metal element different from the metal element applied to the conductive layer, and a second seed layer disposed on the first seed layer and comprising the same metal element as the metal element applied to the conductive layer. For example, the first seed layer may comprise a material such as titanium, chromium, nickel, or the like, and the second seed layer may comprise a material such as copper, nickel, aluminum, gold, or silver, or the like.

The description of the seed layer is redundant and will be skipped.

In the ion beam deposition process for seed layer formation, the atmosphere pressure may be 0.05 Pa or more. The pressure may be greater than or equal to 0.1 Pa. The pressure may be 1 Pa or less. In such cases, the seed layer can be formed at an improved deposition rate.

The sputter power applied in the ion beam deposition process for forming the seed layer may be 10 kW or more. The sputter power may be 15 kW or more. The sputter power may be 20 kW or more. The sputter power may be 100 kW or less. The sputter power may be 50 kW or less. In such cases, the sputter particles may collide on the surface to be deposited with a controlled kinetic energy. This allows for more robust formation of the seed layer on the glass core while preventing excessive deviation in the roughness characteristics of the glass core surface.

In ion beam deposition processes for seed layer formation, an argon ion beam may be applied.

In an ion beam deposition process for seed layer formation, the sputter target may comprise the metal element applied to the layer to be deposited.

The ion beam deposition process for forming the first seed layer may be carried out for 5 minutes or more. The deposition process may be carried out for 10 minutes or more. The deposition process may be carried out for 20 minutes or more. The deposition process may be carried out 60 minutes or less.

The ion beam deposition process for forming the second seed layer may be carried out for 5 minutes or more. The deposition process may be carried out for 10 minutes or more. The deposition process may be carried out for longer than 20 minutes. The deposition process may be carried out 60 minutes or less.

In this case, a seed layer with a structure that stably bonds to the top surface of the glass core can be formed.

After the seed layer is formed, the portion of the seed layer that does not require the formation of an electrically conductive layer may be removed. A plating activation/deactivation treatment may be applied to the portion of the seed layer that is required to form an electrically conductive layer and the portion that is not required. The plating activation/deactivation treatment may be applied, for example, through light irradiation treatment using a laser of a specific wavelength, chemical treatment, etc. However, it is possible to form a conductive layer on the seed layer without applying the above treatment.

The description of the structure and material of the seed layer is redundant and will be omitted.

A conductive layer may be formed by a plating process on the seed layer to provide an electrically conductive layer. A description of the material of the conductive layer is omitted as it is redundant to the preceding description. After forming the conductive layer, the electrically conductive layer may be etched so that the electrically conductive layer has a pre-designed pattern shape.

After forming the electrically conductive layer, an insulating layer surrounding at least a portion of the electrically conductive layer may be disposed to form a core distribution layer. The insulating layer may exemplarily include an epoxy-based resin including a filler. The insulating layer may be formed by, but is not limited to, a build-up layer material such as Ajinomoto Build-up Film (ABF) from Ajinomoto, an undercoat material, and the like.

The insulating layer can be formed by laminating uncured or semi-cured insulator films and then curing them.

The operation of forming a core distribution layer may include forming a core distribution layer over the glass core. The operation of forming a core distribution layer may comprise forming a core distribution layer above and below the glass core. The operation of forming a core distribution layer may include forming a core distribution layer over and below the glass core and within the core via. A description of the method of forming a core distribution layer under the glass core and in the core via is omitted as it is redundant to the preceding description.

Optionally, the method of manufacturing the substrate of an embodiment may further comprise the operation of forming a top distribution layer above top of the core distribution layer disposed on the glass core. The top distribution layer includes an electrically conductive layer and an insulating layer surrounding at least a portion of the electrically conductive layer.

The method of manufacturing the substrate of an embodiment may further comprise the operation of forming a bottom distribution layer and/or a bump below the core distribution layer disposed below the glass core. The bottom distribution layer includes an electrically conductive layer and an insulating layer surrounding at least a portion of the electrically conductive layer.

The electrically conductive and insulating layers applied to the upper and lower distribution layers may be of the same material and manufacturing method as the electrically conductive and insulating layers applied to the core distribution layer.

Specific embodiments will be described in more detail below. The following embodiments are illustrative only to aid in understanding the disclosure and are not intended to limit the scope of the disclosure.

**Manufacturing Example: Manufacturing of a substrate**

Manufacture Example 1: The top surface of a basic glass plate, an alkali-free glass substrate of 0.4T thickness, was treated with argon plasma for 30 to 60 seconds to prepare a glass core with a top surface having root mean square deviation Rq value of 1.73 nm. The argon plasma treatment was performed at atmosphere pressure of 10 mTorr, an argon gas flow rate of 300 sccm, a source power of 1 kW, and a bias power of 1 kW.

Manufacture Example 2: The top surface of the base glass plate, a soda lime glass substrate with 0.55T thickness, was treated with argon plasma for 30 to 60 seconds to prepare a glass core with a top surface having root mean square deviation Rq value of 0.45 nm. The argon plasma process conditions were the same as in Manufacture Example 1.

Manufacture Example 3: Corning's SG7.8 glass substrate with a thickness of 0.5T as the base glass plate was treated with argon plasma for 30 to 60 seconds to prepare a glass core with a top surface having root mean square deviation Rq value of 0.34 nm. The argon plasma process conditions were the same as in Manufacture Example 1.

Manufacture Example 4: The top surface of an alkali-free glass substrate with a thickness of 0.4T, which is a basic glass plate, was treated with argon plasma for 30 to 120 seconds to prepare a glass core with a top surface having a root mean square deviation Rq value of 0.35 nm. The argon plasma treatment was performed at a pressure of 10 mTorr, an argon gas flow rate of 300 sccm, a source power of 1.5 kW, and a bias power of 2.5 kW.

Manufacture Example 5: The top surface of soda-lime glass substrate with 0.55T thickness as a base glass plate was treated with argon plasma for 30 to 120 seconds to prepare a glass core with a top surface having root mean square deviation Rq value of 0.27 nm. The argon plasma process conditions were the same as in Manufacture Example 4.

Manufacture Example 6: Corning's SG7.8 glass substrate with a thickness of 0.5T as the base glass plate was treated with argon plasma for 30 to 120 seconds to prepare a glass core with a top surface having root mean square deviation Rq value of 0.22 nm on the top surface. The argon plasma process conditions were the same as in Manufacture Example 4.

Manufacture Example 7: The top surface of Corning's SG7.8 glass substrate, which is 0.5T thick with a base glass plate, was treated with argon plasma for 30 to 120 seconds to produce a glass core with a top surface having root mean square deviation Rq value of 0.26 nm. The argon plasma process conditions were the same as in Manufacture Example 4.

**Evaluation Example: Measuring Roughness Characteristics**

A total of three arbitrarily selected measurement areas of 5 $\mu$m in width and 5 $\mu$m in length were designated on the upper surface of the glass core of the manufacturer example. The measurement areas were selected so that they do not overlap each other. The Rq and Rku values of each measurement area were measured in non-contact mode with an atomic force microscope XE-100 of Park Systems in accordance with ISO 4287. The average value of the Rq value and the average value of the Rku value for each measuring area was taken as the Rq value and the Rku value of the top surface of the glass core of the manufacture examples.

Then, the standard deviation of the Rku value and the standard deviation of the Rq value of each manufacturing example were calculated from the Rku value and the Rq value of each measurement area of the manufacturer examples.

Then, the $R_{q*k}$ value was calculated from the calculated Rku value and Rq value for each manufacturer example above.

The measurement and calculation results for each manufacturer example are shown in Tables 1 and 2 below.

**Evaluation Example: Evaluating the Bonding Force of an Electrically Conductive Layer**

A titanium layer with a thickness of 300 nm was formed on the top surface of the glass core of the manufacture examples by an ion beam deposition process and a copper layer with a thickness of 300 nm on the titanium layer were formed by an ion beam deposition process to prepare a seed layer. The titanium layer and the copper layer were formed by ion beam deposition for 30 minutes at an atmosphere pressure of 0.2 Pa and a sputter power of 30 kW, respectively.

A conductive layer with a thickness of 20 $\mu$m was formed by a copper plating process on the above seed layer to provide an electrically conductive layer.

The bonding force of the electrically conductive layer to the glass core was then measured with a Condor Sigma bond tester from XYZ TEC according to the 180° peel test. The measuring speed was set to 10 mm/s and the measuring distance to 70 mm.

The measurement results for each manufacturer examples are shown in Table 1 below.

**Evaluation Example: Assessing Delamination of an Electrically Conductive Layer 1**

A titanium layer with a thickness of 300 nm and a copper layer with a thickness of 300 nm were formed on the top surface of the glass core of the manufacture examples were deposited by an ion beam deposition process to form a seed layer. The titanium and copper layers were each deposited for 30 minutes at an atmosphere pressure of 0.2 Pa and a sputter power of 30 kW respectively. A conductive layer with a thickness of 20 $\mu$m was formed by a copper plating process on the seed layer to provide an electrically conductive layer.

Singulation was performed at the glass core on which the electrically conductive layer was formed. Specifically, energy was applied to the dicing path on the upper surface of the glass core through a laser device, and the glass core was cut by applying a physical force. Then, grinding was performed on the edge of the cut glass core.

The cross-section of the singulated glass core was examined under an optical microscope to check for delamination of the electrically conductive layer. The cross-sections were evaluated as P if no delamination of the electrically conductive layer was observed and F if delamination of the electrically conductive layer was observed.

The measurement results for each manufacture example are shown in Table 1 below.

**Evaluation Example: Assessing Delamination of an Electrically Conductive Layer 2**

A titanium layer with a thickness of 300 nm and a copper layer with a thickness of 300 nm on the top surface of the glass core of the manufacture examples were deposited by an ion beam deposition process to form a seed layer. The titanium and copper layers were each deposited for 30 minutes at an atmospheric pressure of 0.2 Pa and a sputter power of 30 kW respectively. A conductive layer with a thickness of 20 $\mu$m was formed by copper plating process on the seed layer to provide an electrically conductive layer.

The glass core with the formed electrically conductive layer was left in an environment of 125°C for 25 hours. The glass core was then left at 150°C for 500 hours.

When visually observing the substrate of each manufacturing example after leaving, the substrate was evaluated as P if no delamination of the electrically conductive layer occurred or F if delamination of the electrically conductive layer occurred.

The measurement results for each manufacture example are shown in Table 1 below.

[Table 1]

| | $R_{q*k}$ (nm) | Rq (nm) | Rku | Bonding force (kgf) | Delamination Assessment 1 | Delamination Assessment 2 |
|---|---|---|---|---|---|---|
| Manufacture Example 1 | 23.56 | 1.73 | 3.69 | 0.52 | P | P |

(continued)

| | $R_{q*k}$ (nm) | Rq (nm) | Rku | Bonding force (kgf) | Delamination Assessment 1 | Delamination Assessment 2 |
|---|---|---|---|---|---|---|
| Manufacture Example 2 | 49.14 | 0.45 | 10.45 | 0.48 | P | P |
| Manufacture Example 3 | 11.05 | 0.34 | 5.7 | 0.64 | P | P |
| Manufacture Example 4 | 6.71 | 0.35 | 4.38 | 0.33 | P | F |
| Manufacture Example 5 | 3.56 | 0.27 | 3.63 | 0.25 | F | P |
| Manufacture Example 6 | 1.90 | 0.22 | 2.94 | 0.21 | F | F |
| Manufacture Example 7 | 3.39 | 0.26 | 3.61 | 0.21 | F | F |

[Table 2]

| | Measurement Area | Rq (nm) | Rq Average value (nm) | Rq Standard deviation (nm) | Rku | Rku Average value | Rku Standard deviation |
|---|---|---|---|---|---|---|---|
| Manufacture Example1 | Measurement Area1 | 1.7 | | | 3.93 | | |
| | Measurement Area2 | 1.699 | 1.73 | 0.059 | 3.34 | 3.69 | 0.308 |
| | Measurement Area3 | 1.801 | | | 3.79 | | |
| Manufacture Example2 | Measurement Area1 | 0.409 | | | 9.62 | | |
| | Measurement Area2 | 0.491 | 0.45 | 0.041 | 10.53 | 10.45 | 0.788 |
| | Measurement Area3 | 0.442 | | | 11.19 | | |
| Manufacture Example3 | Measurement Area1 | 0.341 | | | 5.8 | | |
| | Measurement Area2 | 0.357 | 0.34 | 0.011 | 6.01 | 5.7 | 0.370 |
| | Measurement Area3 | 0.335 | | | 5.29 | | |
| Manufacture Example4 | Measurement Area1 | 0.412 | | | 5.06 | | |
| | Measurement Area2 | 0.358 | 0.35 | 0.073 | 4.11 | 4.38 | 0.593 |
| | Measurement Area3 | 0.267 | | | 3.97 | | |
| Manufacture Example5 | Measurement Area1 | 0.228 | | | 2.62 | | |
| | Measurement Area2 | 0.264 | 0.27 | 0.048 | 4.31 | 3.63 | 0.890 |
| | Measurement Area3 | 0.324 | | | 3.95 | | |
| Manufacture Example6 | Measurement Area1 | 0.207 | | | 2.98 | | |
| | Measurement Area2 | 0.251 | 0.22 | 0.025 | 2.71 | 2.94 | 0.217 |
| | Measurement Area3 | 0.207 | | | 3.14 | | |
| Manufacture Example7 | Measurement Area1 | 0.247 | | | 3.1 | | |
| | Measurement Area2 | 0.251 | 0.26 | 0.022 | 4.41 | 3.61 | 0.699 |
| | Measurement Area3 | 0.287 | | | 3.33 | | |

In Table 1 above, for Manufacture Examples 1 to 5, where the $R_{q*k}$ values were controlled to be 3.5 nm to 150 nm, the electrically conductive layer exhibited a bonding force of 0.25 kgf or more when formed on the glass core, and no peeling of the electrically conductive layer was observed in the two peel tests. On the other hand, in the case of Manufacture Examples 6 and 7, where the $R_{q*k}$ value was less than 3.5 nm, the bonding force of the electrically conductive layer on the glass core was measured to be 0.4 kgf or less and peeling of the electrically conductive layer occurred at least once in two peeling tests.

In Table 2 above, the standard deviations of the Rq values of each measured area of the manufacture examples are less than or equal to 0.1 nm, and the standard deviations of the Rku values of each measured area are less than or equal to 1. This indicates that the roughness characteristics of the glass core top surface of the manufacture examples are even throughout.

Although preferred embodiments of the present disclosure have been described in detail above, the scope of the disclosure is not limited thereto, and various modifications and improvements by those skilled in the art utilizing the basic concepts of the disclosure as defined in the following claims are also within the scope of the disclosure.

[Description of Signs]

100: Substrate
10: Glass Core
11: Glass Core Top Surface 12: Glass Core Bottom Surface
20: Electrically Conductive Layer
21: Seed Layer 22: Conductive Layer
25: First Electrically Conductive Layer 26: Second Electrically Conductive Layer
30: Insulating Layer
50: Core Distribution Layer
L: Interface formed between the first electrically conductive layer and the glass core

**Claims**

1. A substrate comprising:

   a glass core having a top surface;
   wherein the top surface of the glass core has a value of $R_{q*k}$, bond roughness index of Equation 1 below, from 3.5 nm to 150 nm:

   [Equation 1]

   $$R_{q*k} = Rq \times Rku^2$$

   wherein Rq is root mean square deviation (in nm) and Rku is kurtosis.

2. The substrate of claim 1,
   wherein the Rq value is from 0.25 nm to 5 nm.

3. The substrate of claim 1,
   wherein the Rku value is 3 or greater.

4. The substrate of claim 1,

   wherein the top surface of the glass core has three arbitrarily selected measurement areas, and
   a standard deviation of the Rq values of each measurement area is 0.15 nm or less.

5. The substrate of claim 1,

   wherein the top surface of the glass core has three arbitrarily selected measurement areas, and
   a standard deviation of the Rku values of each measurement area is 1 or less.

6. The substrate of claim 1,
   further comprising an electrically conductive layer disposed on the glass core.

7. The substrate of claim 6,

   wherein the electrically conductive layer comprises a seed layer and a conductive layer disposed on the seed layer, and

a thickness of the seed layer is from 50 nm to 1500 nm.

8. The substrate of claim 6,

   wherein the electrically conductive layer has a pattern shape,
   a width of the electrically conductive layer is from 1 $\mu$m to 5 $\mu$m, and
   a thickness of the electrically conductive layer is from 1 $\mu$m to 5 $\mu$m.

9. The substrate of claim 6,

   wherein the electrically conductive layer comprises a first electrically conductive layer formed in contact with the top surface of the glass core, and
   maximum height roughness (Rz) value of an interface formed between the first electrically conductive layer and the glass core, when observed in cross-section of the first electrically conductive layer, is from 5 nm to 200 nm.

10. The substrate of claim 6,

    wherein the electrically conductive layer comprises a first electrically conductive layer formed in contact with the top surface of the glass core, and
    bonding force between the first electrically conductive layer and the glass core, as measured by a 180° peel test, is 0.25 kgf or greater.

11. The substrate of claim 1,
    wherein the substrate is for semiconductor packaging.

12. A method of manufacturing a substrate, comprising:

    preparing a base glass plate; and
    roughening a top surface of the base glass plate to form a glass core;
    wherein a top surface of the glass core has a value of $R_{q*k}$, a bond roughness index of Equation 1 below, from 3.5 nm to 150 nm:

[Equation 1]

$$R_{q*k} = Rq \times Rku^2$$

wherein Rq is root mean square deviation (in nm) and Rku is kurtosis.

13. The method of claim 12,
    wherein the roughening comprises plasma treating the top surface of the base glass plate to form the glass core.

[FIG. 1]

<u>100</u>

11

10

[FIG. 2]

<u>100</u>

11

20

10

[FIG. 3]

<u>100</u>

11

22
21
20

10

[FIG. 4]

Europäisches
Patentamt

European
Patent Office

Office européen
des brevets

# EUROPEAN SEARCH REPORT

Application Number

EP 24 19 2913

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 946 546 A (BOURGEOIS-MOINE JEAN-PAUL [FR]) 7 August 1990 (1990-08-07) * column 1, line 5 - line 17 * * column 5, line 26 - line 40 * * column 6, line 19 - line 63 * ----- | 1-13 | INV. C03C17/36 C03C17/40 C03C23/00 |
| X | US 2003/132524 A1 (FELMETSGER VALERY V [US]) 17 July 2003 (2003-07-17) * paragraphs [0002] - [0007], [0010], [0011], [0018], [0027], [0031] - [0033], [0037] * ----- | 1-13 | |
| X | NOVOTNA ZDENKA ET AL: "Cells adhesion and growth on gold nanoparticle grafted glass", APPLIED SURFACE SCIENCE,, vol. 307, 13 April 2014 (2014-04-13), pages 217-223, XP029026185, DOI: 10.1016/J.APSUSC.2014.04.017 * Section 2 "Materials and methods" * ----- | 1-6,12, 13 | |
| X | TERPILOWSKI KONRAD ET AL: "Surface properties of glass plates activated by air, oxygen, nitrogen and argon plasma", GLASS PHYSICS AND CHEMISTRY, PLEIADES PUBLISHING, US, vol. 42, no. 6, 2 December 2016 (2016-12-02), pages 535-541, XP036109748, ISSN: 1087-6596, DOI: 10.1134/S1087659616060195 [retrieved on 2016-12-02] * Sections: "Surface Characterization", "Plasma Surface Treatment", table 1 * ----- | 1-5,12, 13 | **TECHNICAL FIELDS SEARCHED (IPC)** C03C |

The present search report has been drawn up for all claims

| Place of search | Date of completion of the search | Examiner |
|---|---|---|
| Munich | 24 January 2025 | King, Ruth |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 2913

This annex lists the patent family members relating to the patent documents cited in the above-mentioned European search report.
The members are as contained in the European Patent Office EDP file on
The European Patent Office is in no way liable for these particulars which are merely given for the purpose of information.

24-01-2025

| Patent document cited in search report | | Publication date | Patent family member(s) | | Publication date |
|---|---|---|---|---|---|
| US 4946546 | A | 07-08-1990 | DE | 3872859 T2 | 18-02-1993 |
| | | | EP | 0322967 A1 | 05-07-1989 |
| | | | FR | 2625190 A1 | 30-06-1989 |
| | | | JP | H01212754 A | 25-08-1989 |
| | | | KR | 890011041 A | 12-08-1989 |
| | | | US | 4946546 A | 07-08-1990 |
| US 2003132524 | A1 | 17-07-2003 | AU | 2002346401 A1 | 02-09-2003 |
| | | | CA | 2468806 A1 | 31-07-2003 |
| | | | CN | 1610764 A | 27-04-2005 |
| | | | EP | 1516354 A2 | 23-03-2005 |
| | | | JP | 2005517086 A | 09-06-2005 |
| | | | KR | 20040072728 A | 18-08-2004 |
| | | | US | 2003132524 A1 | 17-07-2003 |
| | | | WO | 03063200 A2 | 31-07-2003 |

EPO FORM P0459

For more details about this annex : see Official Journal of the European Patent Office, No. 12/82